# EUROPEAN PATENT APPLICATION

(11) **EP 3 346 218 A1**
(43) Date of publication of application: **11.07.2018**
(21) Application number: 17171848.9
(22) Date of filing: 19.05.2017
(51) Int. Cl.: F28D 1/053, H01L 23/473, G06F 1/20

(54) **AN INTEGRATED LIQUID COOLING DEVICE AND A METHOD THEREOF**

(30) Priority: 09.01.2017 CN 201710012181
(71) Applicant: Blackbezt Lighting Technology Co., Ltd., Foshan City, Guangdong Province 528000 (CN)
(72) Inventor: MAI, Jianwen, Guangzhou, Guangdong 510000 (CN)
(74) Representative: Sun, Yiming

(57) **Abstract**

An integrated liquid cooling device comprises a housing, a first liquid reservoir, a second liquid reservoir, at least one first liquid channel for heat dissipation, a second liquid channel appressed to a heat source device, at least one third liquid channel for heat dissipation and a liquid transfer cycle driver; the first liquid reservoir is connected to the second liquid channel through the first liquid channel; the second liquid channel is connected to the second liquid reservoir through the third liquid channel; the first liquid reservoir and the second liquid reservoir are independent to each other and connected through the liquid transfer cycle driver; the liquid transfer cycle driver transfers the liquid in the second liquid reservoir to the first liquid reservoir. The invention saves the space and reducing the risk of leakage.

## Description

### Technical Field

The Invention relates to the technical field of heat energy transfer device, and particularly to an integrated liquid cooling device and a method thereof.

### Background Art

In prior art, the CPU (Central Processing Unit) of desk computers, servers and laptops is cooled with fan at present. The core parts of these products will emit much heat during operation, while the poor effect of heat dissipation may seriously affect the application and service life of the products. All sorts of lamps will also emit much heat during illumination. The increased temperature of the products during operation may seriously affect their service life and waste the energy. The core parts of all kinds of electronic equipment will emit much heat during operation, and the performance of the equipment will be seriously affected by the heat failed to be dissipated. Some amateurs use water to cool the computers with DIY device, but the problems as leakage of water pipeline and connectors and aging of plastic pipelines in high-temperature water may occur. In addition, such cooling method needs water tank, pump and fan arranged separately and taking up a lot of space, therefore, it cannot be industrialized on a large scale.

### Summary of the Invention

The invention is to disclose an integrated liquid cooling device and a method thereof, so as to solve the problem that much heat will be emitted by the core parts of existing electronic products as computers, servers and lamps, and degrade the performance of the products and waste the energy.

The invention uses the following technical schemes to achieve the above purpose:
An integrated liquid cooling device, comprising a housing, a first liquid reservoir, a second liquid reservoir, at least one first liquid channel for heat dissipation, a second liquid channel appressed to a heat source device, at least one third liquid channel for heat dissipation and a liquid transfer cycle driver; the first liquid reservoir, the second liquid reservoir, the first liquid channel, the second liquid channel, the third liquid channel and the liquid transfer cycle driver are arranged in the housing; the first liquid reservoir is connected to the second liquid channel through the first liquid channel; the second liquid channel is connected to the second liquid reservoir through the third liquid channel; the first liquid reservoir and the second liquid reservoir are independent to each other and connected through the liquid transfer cycle driver; the liquid transfer cycle driver transfers the liquid in the second liquid reservoir to the first liquid reservoir.

Further, said first liquid channel has the same structure with said third liquid channel; the first liquid channel comprises a pipeline and a cooling fin for heat dissipation; the cooling fin is arranged on the outer wall of the pipeline.

Further, said first liquid channel and said third liquid channel are arranged in parallel; the upper end of the first liquid channel is connected to said first liquid reservoir; the lower end of the first liquid channel is connected to said second liquid channel; the upper end of the third liquid channel is connected to said second liquid reservoir and the lower end of the third liquid channel is connected to said second liquid channel.

Further, it comprises a fan arranged on the housing for heat dissipation; the fan is arranged on one side or both sides of said first liquid channel and said third liquid channel.

Further, said housing is made of metal materials conducive to heat dissipation.

Further, the cross section of said first liquid channel and said second liquid channel is elliptic or quadrate.

Further, it comprises 7 said first liquid channels and 6 said third liquid channels.

The Invention further discloses a liquid cooling method by using said integrated liquid cooling device, comprising that: said first liquid reservoir, said first liquid channel, said second liquid channel, said third liquid channel and said second liquid reservoir form a complete flowing path in said housing; the liquid transfer cycle driver drives the liquid to enter the first liquid reservoir through the second liquid reservoir; the liquid flows circularly in the housing through such driving; during this process, heat transfer will happen between the liquid in the second liquid channel and the heat source device; the liquid takes away the heat of the heat source device and distribute the heat energy to the surfaces of said cooling fin in the first liquid channel and the cooling fin in the third liquid channel while flowing through the first and third liquid channels so as to realize heat dissipation; meanwhile, said fan rotates to accelerate the air flow so that the heat energy on the surfaces of cooling fin can be taken away by air.

Compared with the prior art, the beneficial effects of the invention lie in that:
1. Said integrated liquid cooling device of the invention uses a structure that the first liquid reservoir, the second liquid reservoir, the first liquid channel, the second liquid channel, the third liquid channel and the liquid transfer cycle driver are arranged in the housing; all parts are internally installed as an integral encapsulation with a simple structure, saving external pipeline and space. The device has low requirements for manufacturing accuracy and installation, improving the safety; with small size, it can be widely used for cooling of heating components of the core parts in all kinds of electronic products, thus ensuring the safety of the electronic products. When all parts are internally installed as an integral encapsulation with less pipeline connecters, the risk of leakage is reduced and the reliability of cooling is increased.
2. The invention provides a new type of integrated liquid cooling device and a method thereof. With a compact structure, the cooling device has low requirements for manufacturing accuracy and installation and has easy and safety operation. The integrated liquid cooling device may use all sorts of metal that is conducive to heat dissipation as the housing. Using flat liquid channel may increase the contact effectiveness between the cooling liquid and the cooling fin, thus greatly improve the overall effect of heat dissipation. The cooling liquid in a fully sealed space flows unidirectionally in cycle through the liquid transfer cycle driver and the heat is driven to cycle by liquid in channels. The product is fully sealed, therefore, no liquid is to be added in the future and no liquid leakage will be worried about.

### Brief Description of the Drawings

In order to illustrate the technical schemes in the embodiments of the Invention or in prior art more clearly, the drawings required in description of the embodiments or prior art will be introduced briefly as follows. Obviously, the drawings described below are just a part of the embodiments of the Invention. A person skilled in the art is able to obtain other drawings according to these drawings without any creative work.
Fig. 1 is a sectional schematic diagram of main view of Embodiment 1 of the integrated liquid cooling device described in the invention. The arrow in the figure indicates the flow direction of the liquid;
Fig. 2 is a top view schematic diagram of Fig. 1.
Fig. 3 is a left view schematic diagram of Fig. 1.

Marks in the figures: 1. Housing; 2. First liquid reservoir; 3. Second liquid reservoir; 4. First liquid channel; 41. Pipeline; 42. Cooling fin for heat dissipation; 5. Second liquid channel; 6. Third liquid channel; 7. Liquid transfer cycle driver; 8. Fan; 9. Heat source device.

### Detailed Description of the Preferred Embodiments

A clear and full description of the technical schemes of the embodiments of the invention will be given in combination of the drawings of the embodiments of the Invention as follows. Obviously, the described embodiments are just a part rather than the whole of the embodiments of the Invention. Based on the embodiments of the Invention, any other embodiments obtained by a person skilled in the art without any creative work will fall within the protection scope of the Invention.

### Embodiment 1

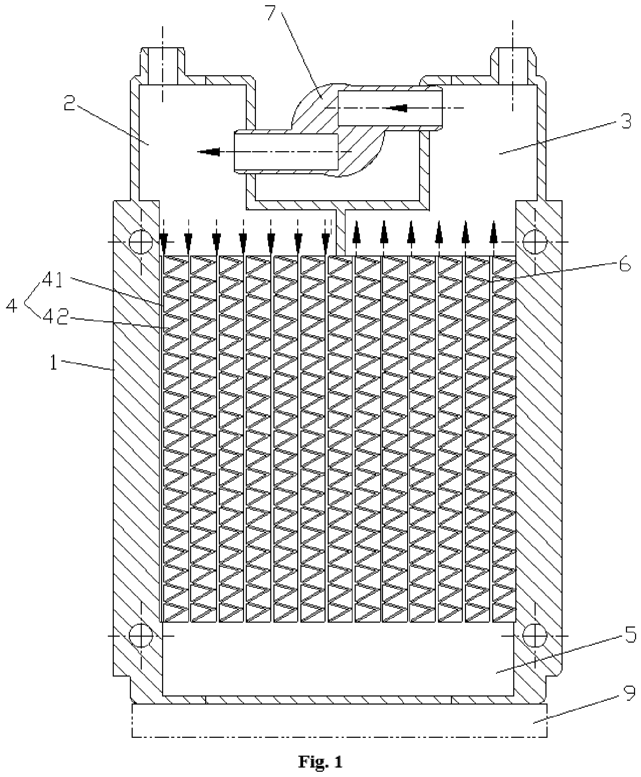

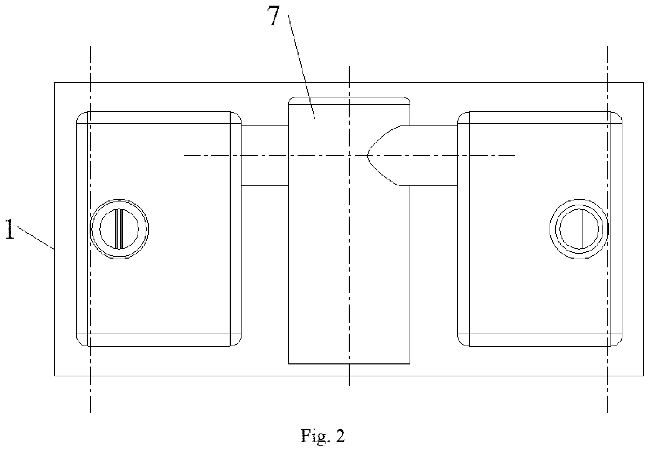

The integrated liquid cooling device of Embodiment 1 as shown in Figs. 1-3, comprises a housing 1, a first liquid reservoir 2, a second liquid reservoir 3, at least one first liquid channel 4 for heat dissipation, a second liquid channel 5 appressed to heat source device 9, at least one third liquid channel 6 for heat dissipation and a liquid transfer cycle driver 7; the first liquid reservoir 2, the second liquid reservoir 3, the first liquid channel 4, the second liquid channel 5, the third liquid channel 6 and the liquid transfer cycle driver 7 are arranged in the housing 1. The first liquid reservoir 2 is connected to the second liquid channel 5 through the first liquid channel 4; the second liquid channel 5 is connected to the second liquid reservoir 3 through the third liquid channel 6; the first liquid reservoir 2 and the second liquid reservoir 3 are independent to each other and connected through the liquid transfer cycle driver 7; the liquid transfer cycle driver 7 transfers the liquid in the second liquid reservoir 3 to the first liquid reservoir 2.The first liquid channel 4 has the same structure with the third liquid channel 6. The first liquid channel 4 comprises a pipeline 41 and a cooling fin 42 for heat dissipation; the cooling fin 42 is arranged on the outer wall of the pipeline. The Embodiment 1 comprises seven first liquid channels 4 and six third liquid channels 6. The first liquid channel 4 and the third liquid channel 6 are arranged in parallel; the upper end of the first liquid channel 4 is connected to the first liquid reservoir 2; the lower end of the first liquid channel 4 is connected to the second liquid channel 5; the upper end of the third liquid channel 6 is connected to the second liquid reservoir 3 and the lower end of the third liquid channel 6 is connected to the second liquid channel 5.

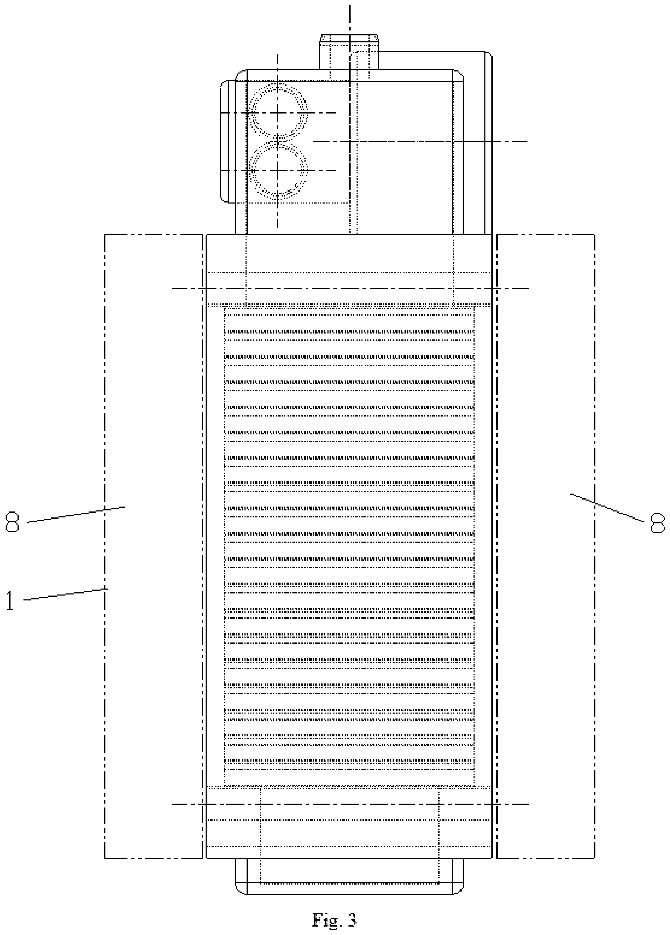

The Embodiment 1 further comprises a fan 8 arranged on the housing 1 for heat dissipation; the fan 8 is arranged on one side or both sides of the first liquid channel 4 and the third liquid channel 6 (as shown in Fig. 3); in Embodiment 1, the fan 8 rotates to accelerate the air flow so that the heat energy on the surfaces of cooling fin in the first liquid channel 4 and the third liquid channel 6 can be taken away by air. Further, in Embodiment 1, housing 1 is made of metal materials conducive to heat dissipation; the cross section of the first liquid channel 4 and the second liquid channel 5 is elliptical, quadrate or of other flat structures so as to increase the contact effectiveness between the cooling liquid and the cooling fin.

Refer to the prior art for other structures of Embodiment 1.

### Embodiment 2

The method of liquid cooling by using Embodiment 1 comprises: the first liquid reservoir 2, the first liquid channel 4, the second liquid channel 5, the third liquid channel 6 and the second liquid reservoir 3 form a complete flowing path in the housing 1; the liquid transfer cycle driver 7 drives the liquid to enter the first liquid reservoir 2 through the second liquid reservoir 3; the liquid flows circularly in the housing 1 through such driving; during this process, heat transfer will happen between the liquid in the second liquid channel 5 and the heat source device 9; the liquid takes away the heat of heat source device 9 and distribute the heat energy to the surfaces of the cooling fin in the first liquid channel 4 and the cooling fin in the third liquid channel 6 while flowing through the first liquid channel 4 and the third liquid channel 6 so as to realize heat dissipation; meanwhile, the fan rotates to accelerate the air flow so that the heat energy on the surfaces of cooling fin can be taken away by air.

The invention is not limited to the above embodiments. In case any amendments or deformations of the Invention not departing from the spirit and scope of the Invention belong to the scope of the Claims and equivalent technology in the Invention, the Invention shall include such amendments and deformations.

## Claims

1. An integrated liquid cooling device, wherein, comprises a housing, a first liquid reservoir, a second liquid reservoir, at least one first liquid channel for heat dissipation, a second liquid channel appressed to a heat source device, at least one third liquid channel for heat dissipation and a liquid transfer cycle driver; the first liquid reservoir, the second liquid reservoir, the first liquid channel, the second liquid channel, the third liquid channel and the liquid transfer cycle driver are arranged in the housing; the first liquid reservoir is connected to the second liquid channel through the first liquid channel; the second liquid channel is connected to the second liquid reservoir through the third liquid channel; the first liquid reservoir and the second liquid reservoir are independent to each other and connected through the liquid transfer cycle driver; the liquid transfer cycle driver transfers the liquid in the second liquid reservoir to the first liquid reservoir.

2. The integrated liquid cooling device according to Claim 1, wherein, the first liquid channel has the same structure with the third liquid channel; the first liquid channel and the third liquid channel all comprise a pipeline and a cooling fin for heat dissipation; the cooling fin is arranged on the outer wall of the pipeline.

3. The integrated liquid cooling device according to Claim 2, wherein, the first liquid channel and the third liquid channel are arranged in parallel; the upper end of the first liquid channel is connected to the first liquid reservoir; the lower end of the first liquid channel is connected to the second liquid channel; the upper end of the third liquid channel is connected to the second liquid reservoir and the lower end of the third liquid channel is connected to the second liquid channel.

4. The integrated liquid cooling device according to Claim 3, wherein, also comprises a fan arranged on the housing for heat dissipation; the fan is arranged on one side or both sides of the first liquid channel and the third liquid channel.

5. The integrated liquid cooling device according to Claim 4, wherein, the housing is made of metal materials conducive to heat dissipation.

6. The integrated liquid cooling device according to Claim 4, wherein, the cross section of the first liquid channel and the second liquid channel is elliptic or quadrate.

7. The integrated liquid cooling device according to Claim 4, wherein, comprises seven the first liquid channels and six the third liquid channels.

8. A liquid cooling method by using the integrated liquid cooling device according to any of Claims 4∼7, wherein, comprises:
forming a complete flowing path in the housing through the first liquid reservoir, the first liquid channel, the second liquid channel, the third liquid channel and the second liquid reservoir;
driving the liquid by the liquid transfer cycle driver entering the first liquid reservoir from the second liquid reservoir and flowing circularly in the housing;
taking away the heat of heat source device by the liquid, and distributing the heat energy to the surfaces of the cooling fin in the first liquid channel and the cooling fin in the third liquid channel while the liquid flowing through the first and third liquid channels so as to realize heat dissipation, and achieving heat transfer between the liquid in the second liquid channel and the heat source device during this process;
accelerating the air flow by the fan rotating so that the heat energy on the surfaces of cooling fin be taken away by air.

## Amended claims

### Amended claims in accordance with Rule 137(2) EPC.

1. An integrated liquid cooling device, comprising a housing (1) and arranged in the housing a first liquid reservoir (2), a second liquid reservoir (3), a second liquid channel (5) appressed to a heat source device (9), and a liquid transfer cycle driver (7), **characterized by** at least one first liquid channel (4) for heat dissipation and at least one third liquid channel (6) for heat dissipation arranged in the housing; the first liquid reservoir being connected to the second liquid channel through the first liquid channel; the second liquid channel being connected to the second liquid reservoir through the third liquid channel; the first liquid reservoir and the second liquid reservoir being independent to each other and connected through the liquid transfer cycle driver; the liquid transfer cycle driver transferring the liquid in the second liquid reservoir to the first liquid reservoir.

2. The integrated liquid cooling device according to Claim 1, **characterized in that**: the first liquid channel has the same structure with the third liquid channel; the first liquid channel and the third liquid channel all comprise a pipeline (41) and a cooling fin (42) for heat dissipation; the cooling fin is arranged on an outer wall of the pipeline.

3. The integrated liquid cooling device according to Claim 2, **characterized in that**: the first liquid channel and the third liquid channel are arranged in parallel; an upper end of the first liquid channel is connected to the first liquid reservoir; a lower end of the first liquid channel is connected to the second liquid channel; an upper end of the third liquid channel is connected to the second liquid reservoir and a lower end of the third liquid channel is connected to the second liquid channel.

4. The integrated liquid cooling device according to Claim 3, **characterized in that**: a fan (8) arranged on the housing for heat dissipation; the fan is arranged on one side or both sides of the first liquid channel and the third liquid channel.

5. The integrated liquid cooling device according to Claim 4, **characterized in that** the housing is made of metal materials conductive to heat dissipation.

6. The integrated liquid cooling device according to Claim 4, **characterized in that** a cross section of the first liquid channel and the second liquid channel is elliptic or quadratic.

7. The integrated liquid cooling device according to Claim 4, **characterized in** comprising seven first liquid channels and six third liquid channels.

8. A liquid cooling method by using the integrated liquid cooling device according to any of Claims 4 to 7, comprising:
forming a complete flowing path in the housing through the first liquid reservoir, the first liquid channel, the second liquid channel, the third liquid channel and the second liquid reservoir;
driving the liquid by the liquid transfer cycle driver entering the first liquid reservoir from the second liquid reservoir and flowing circularly in the housing;
taking away the heat of the heat source device by the liquid, and distributing the heat energy to the surfaces of the cooling fin in the first liquid channel and the cooling fin in the third liquid channel while the liquid flowing through the first and third liquid channels so as to realize heat dissipation, and achieving heat transfer between the liquid in the second liquid channel and the heat source device during this process;
accelerating the air flow by the fan rotating so that the heat energy on the surfaces of cooling fin be taken away by air.
